# EUROPEAN PATENT APPLICATION

(11) **EP 1 763 076 A2**
(43) Date of publication of application: **14.03.2007**
(21) Application number: 06018679.8
(22) Date of filing: 06.09.2006
(51) Int. Cl.: H01L 23/485

(54) **Semiconductor device**

(30) Priority: 13.09.2005 JP 2005265484
(71) Applicant: SEIKO EPSON CORPORATION, Shinjuku-ku, Tokyo 163-0811 (JP)
(72) Inventor: Hashimoto, Nobuaki Seiko Epson Corp., Suwa-shi Nagano-ken 392-8502 (JP)
(74) Representative: HOFFMANN EITLE

(57) **Abstract**

A semiconductor device including: a semiconductor chip in which an integrated circuit is formed; a plurality of electrodes formed in a first region of the semiconductor chip and arranged in a plurality of rows and a plurality of columns; a plurality of resin protrusions formed in a second region of the semiconductor chip, the second region surrounding the first region; and a plurality of electrical connection sections formed on the resin protrusions and electrically connected to the electrodes.

## Description

### BACKGROUND OF THE INVENTION

The present invention relates to a semiconductor device.

In order to reduce the size of electronic parts, it is desirable that a semiconductor device have a small external shape. Along with diversification of the functions of semiconductor devices, the degree of integration of an integrated circuit formed on a semiconductor chip has been increased. Specifically, a semiconductor device has been developed which can satisfy demands for a reduction in size of a semiconductor device and an increase in degree of integration of an integrated circuit.

As a semiconductor device which can satisfy such demands, a semiconductor device has attracted attention which has an external shape almost equal to that of a semiconductor chip (see JP-A-2-272737). According to this type of semiconductor device, the size of the semiconductor device can be reduced by reducing the size of the semiconductor chip.

In order to ensure the reliability of a semiconductor device, an integrated circuit is designed under various limitations. A reduction in the limitations to the integrated circuit design allows a reduction in the integrated circuit region, whereby the size of the semiconductor chip can be reduced. Specifically, a semiconductor device with a small external shape can be manufactured by utilizing a semiconductor chip with reduced limitations to the integrated circuit design.

### SUMMARY

According to one aspect of the invention, there is provided a semiconductor device comprising:
a semiconductor chip in which an integrated circuit is formed;
a plurality of electrodes formed in a first region of the semiconductor chip and arranged in a plurality of rows and a plurality of columns;
a plurality of resin protrusions formed in a second region of the semiconductor chip, the second region surrounding the first region; and
a plurality of electrical connection sections formed on the resin protrusions and electrically connected to the electrodes.

### BRIEF DESCRIPTION OF THE SEVERAL VIEWS OF THE DRAWING

FIG. 1 is a view illustrative of a semiconductor device according to an embodiment of the invention.
FIG. 2 is a view illustrative of a semiconductor device according to an embodiment of the invention.
FIG. 3 is a view illustrative of a semiconductor device according to an embodiment of the invention.
FIG. 4 is a view illustrative of a semiconductor device according to an embodiment of the invention.
FIG. 5 is a view illustrative of a semiconductor device according to an embodiment of the invention.
FIG. 6 is a view illustrative of a semiconductor device according to a modification of an embodiment of the invention.

### DETAILED DESCRIPTION OF THE EMBODIMENT

The invention may provide a semiconductor device which can be reduced in size and exhibits high reliability.
(1) According to one embodiment of the invention, there is provided a semiconductor device comprising:
   a semiconductor chip in which an integrated circuit is formed;
   a plurality of electrodes formed in a first region of the semiconductor chip and arranged in a plurality of rows and a plurality of columns;
   a plurality of resin protrusions formed in a second region of the semiconductor chip, the second region surrounding the first region; and
   a plurality of electrical connection sections formed on the resin protrusions and electrically connected to the electrodes.
   According to this embodiment, a semiconductor device can be provided which can be reduced in size and exhibits high reliability.
(2) In this semiconductor device,
   the electrodes may include a group of electrodes arranged in a plurality of rows and a plurality of columns;
   the electrodes of the group may be disposed at intersection points of first imaginary straight lines extending in parallel with one another and second imaginary straight lines intersecting the first imaginary straight lines; and
   part of the electrical connection sections electrically connected to the electrodes of the group may be formed on at least one of the resin protrusions extending parallel to the first imaginary straight lines, the number of the resin protrusions on which the part of the electrical connection sections are formed being less than the number of the first imaginary straight lines.
(3) In this semiconductor device, the part of the electrical connection sections electrically connected to the electrodes of the group may be formed on one of the resin protrusions.
(4) In this semiconductor device, the first and second imaginary straight lines may perpendicularly intersect.
(5) In this semiconductor device, the first and second imaginary straight lines may diagonally intersect.
(6) In this semiconductor device,
   the semiconductor chip may be rectangular; and
   the first imaginary straight lines may be parallel to short sides of the semiconductor chip.
(7) In this semiconductor device,
   the semiconductor chip may be rectangular; and
   the first imaginary straight lines may be parallel to long sides of the semiconductor chip.
(8) In this semiconductor device,
   a plurality of I/O cells arranged in a plurality of rows and a plurality of columns may be formed on the semiconductor chip; and
   each of the electrodes may be electrically connected to one of the I/O cells.
   According to the above features, the integrated circuit region of the semiconductor chip can be reduced. Therefore, a semiconductor chip with a small external shape can be utilized, whereby the size of the semiconductor device can be further reduced.
(9) In this semiconductor device, each of the electrodes of the group may be formed on corresponding one of the I/O cells.
   This allows provision of a semiconductor device which can be further reduced in size.
(10) In this semiconductor device, the electrodes may be formed to cover at least part of the integrated circuit.

Embodiments of the invention will be described below with reference to the drawings. Note that the invention is not limited to the following embodiments. The invention also includes a configuration in which the following embodiments and modifications are arbitrarily combined.

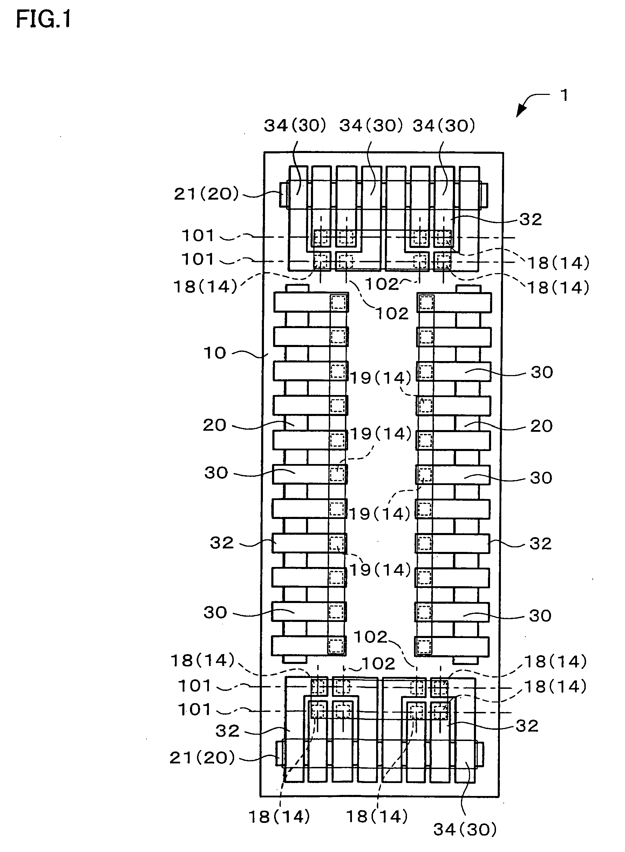

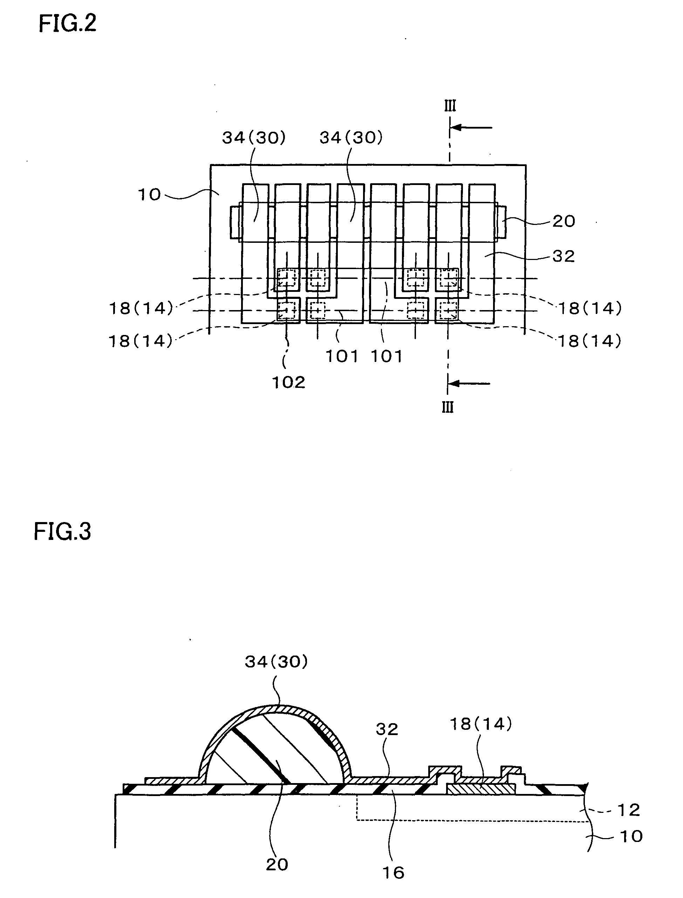

A semiconductor device according to an embodiment to which the invention is applied is described below with reference to FIGS. 1 to 3. FIG. 1 is a schematic view of a semiconductor device 1 according to an embodiment to which the invention is applied. FIG. 2 is a partially enlarged view of FIG. 1. FIG 3 is a partially enlarged view along the line III-III in FIG. 2.

As shown in FIGS. 1 to 3, the semiconductor device according to this embodiment includes a semiconductor chip 10. The semiconductor chip 1O may be a silicon substrate or the like. An integrated circuit 12 may be formed on the semiconductor chip 10 (see FIG. 3). The configuration of the integrated circuit 12 is not particularly limited. For example, the integrated circuit 12 may include an active element such as a transistor and a passive element such as a resistor, coil, or capacitor. The surface (active surface) of the semiconductor chip 10 on which the integrated circuit 12 is formed may be rectangular (see FIG. 1). The active surface of the semiconductor chip 10 may be square (not shown). The invention may be extended to a semiconductor wafer including a plurality of semiconductor chips (not shown). In this case, the semiconductor wafer may include regions in which the semiconductor chips are respectively formed.

As shown in FIGS. 1 to 3, the semiconductor device according to this embodiment includes a plurality of electrodes 14 formed on the semiconductor chip 10. The electrodes 14 are arranged in rows and columns. The electrodes 14 are formed in a first region of the semiconductor chip 10. The region of the semiconductor chip in which the electrodes 14 are formed may be called a first region. The electrodes 14 may be formed on the surface (active surface) of the semiconductor chip 10 on which the integrated circuit 12 is formed. The electrode 14 may be formed to overlap at least part of the integrated circuit 12. In this case, the integrated circuit 12 may be formed to overlap at least part of the first region. The electrode 14 may be formed to overlap a transistor forming the integrated circuit 12, for example. The electrode 14 may be electrically connected with the integrated circuit 12. A conductor which is not electrically connected with the integrated circuit 12 may also be called the electrode 14. The electrode 14 may be part of an internal interconnect of the semiconductor chip. The electrode 14 may be formed of a metal such as aluminum or copper. A passivation film 16 may be formed on the semiconductor chip 10. In this case, the passivation film 16 may be formed to expose the electrode 14 (see FIG 3). The passivation film may be an inorganic insulating film formed of SiO₂, SiN, or the like. The passivation film 16 may be an organic insulating film formed of a polyimide resin or the like.

As shown in FIGS. 1 and 2, the electrodes 14 may include a group of electrodes 18 arranged in rows and columns. The electrodes 18 may be disposed at the intersection points of first imaginary straight lines 101 extending in parallel and second imaginary straight lines 102 intersecting the first imaginary straight lines 101. As shown in FIGS. 1 and 2, one group of electrodes 18 may be disposed on two first imaginary straight lines 101. Note that one group of electrodes 18 may be disposed on three or more first imaginary straight lines 101 (not shown). When the semiconductor chip 10 (active surface of the semiconductor chip 10) is rectangular, the first imaginary straight line 101 may be a straight line extending parallel to the short side of the rectangle. The first imaginary straight line 101 may be a straight line extending parallel to the long side of the semiconductor chip 10. The second imaginary straight line 102 may be a straight line perpendicularly intersecting the first imaginary straight line 101. The second imaginary straight line 102 may be a straight line diagonally intersecting the first imaginary straight line 101. As shown in FIGS. 1 and 2, the electrodes 18 may be arranged in four rows and two columns, for example. Note that the semiconductor device according to this embodiment is not limited thereto. The electrodes 18 may be arranged in M rows and N columns (M and N are integers of two or more).

The electrodes 14 may further include another group of electrodes 19 arranged along a straight line extending in a direction which intersects the first imaginary straight line 101. When the semiconductor chip 10 (active surface of the semiconductor chip 10) is rectangular, the electrodes 19 may be arranged along the long side of the rectangle. As shown in FIG. 1, the electrodes 19 may be arranged in line along the long side. Note that the electrodes 19 may be arranged in columns along the long side. Specifically, the electrodes 19 may be arranged in rows and columns.

I/O cells arranged in rows and columns may be formed on the semiconductor chip 10. The electrode 14 may be electrically connected with the I/O cell. The I/O cells electrically connected with one group of electrodes 18 may be arranged in rows and columns. In this case, the electrodes 18 may be formed on the corresponding I/O cells. The electrodes 19 may be formed on the corresponding I/O cells. In this case, all the electrodes 14 may be formed on the corresponding I/O cells.

As shown in FIG. 1, the semiconductor device according to this embodiment includes a plurality of resin protrusions 20 formed on the semiconductor chip 10. The resin protrusions 20 are formed on the surface (active surface) of the semiconductor chip 10 on which the electrodes 14 are formed. The resin protrusions 20 may be formed on the passivation film 16. The resin protrusions 20 are formed in a second region which encloses the first region. Specifically, the resin protrusions 20 may be formed (only) in,a region outside the region in which the electrodes 14 are formed. The resin protrusions 20 may be formed (only) in a region outside the region in which the integrated circuit 12 is formed. The semiconductor device according to this embodiment may include an electrode disposed in a region outside the resin protrusion 20 (integrated circuit 12) (not shown). In the semiconductor device according to this embodiment, only one resin protrusion may be integrally formed on one semiconductor chip. In this case, the resin protrusion may be formed in the second region to enclose the first region.

The material for the resin protrusion 20 is not particularly limited. A known material may be used. For example, the resin protrusion 20 may be formed of a resin such as a polyimide resin, silicone-modified polyimide resin, epoxy resin, silicone-modified epoxy resin, benzocyclobutene (BCB), polybenzoxazole (PBO), or phenol resin. The shape of the resin protrusion 20 is not particularly limited. For example, the resin protrusion 20 may be formed linearly (see FIG. 1). In this case, the resin protrusion 20 may be formed to extend along the side of the semiconductor chip 10. The resin protrusion 20 may include a resin protrusion 21 having a shape extending parallel to the first imaginary straight line 101. The resin protrusion 21 may have a shape extending along the short side of the semiconductor chip 10. The surface of the resin protrusion 20 may be curved. In this case, the cross-sectional shape of the resin protrusion 20 may be a semicircle, as shown in FIG 2. The resin protrusion 20 may have a hemispherical shape (not shown).

The semiconductor device according to this embodiment includes a plurality of electrical connection sections 30. The electrical connection sections 30 are formed on the resin protrusion 20. The electrical connection sections 30 are electrically connected with the electrodes 14, respectively. For example, the electrical connection section 30 may refer to part (region overlapping the resin protrusion 20) of the interconnect 32 which is pulled from the electrode 14 and extends over the resin protrusion 20. As shown in FIG. 1, a plurality of electrical connection sections 30 may be formed on one resin protrusion 20. Note that only one electrical connection section 30 may be formed on one resin protrusion 20 (not shown).

In the semiconductor device according to this embodiment, electrical connection sections 34 electrically connected with one group of electrodes 18 may be formed on the resin protrusion 20 (resin protrusion 21) in a number less than the number of first imaginary straight lines 101. In this case, the resin protrusion 20 may have a shape extending along the first imaginary straight line 101. Specifically, the electrical connection sections 34 electrically connected with one group of electrodes 18 may be arranged so that the electrical connection sections 34 can be divided into groups extending along the first imaginary straight line 101 in a number (e.g. one) less than the number of first imaginary straight lines 101. For example, all the electrical connection sections 34 electrically connected with one group of electrodes 18 may be formed on one resin protrusion 20 (resin protrusion 21), as shown in FIG. 1.

The structure and the material for the interconnect 32 (electrical connection sections 30 and 34) are not particularly limited. For example, the interconnect 32 may be formed of a single layer. Or, the interconnect 32 may be formed of a plurality of layers. In this case, the interconnect 32 may include a first layer formed of titanium tungsten and a second layer formed of gold (not shown).

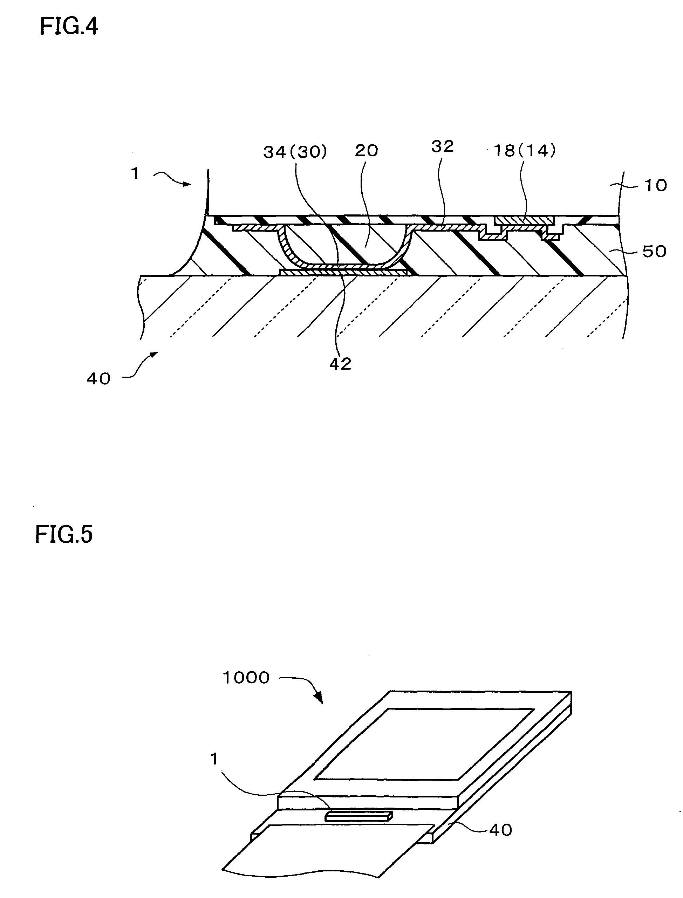

The semiconductor device 1 according to this embodiment may have the above-described configuration. FIG. 4 illustrates a state in which the semiconductor device 1 is mounted on an interconnect substrate 40. The interconnect substrate 40 may be a rigid substrate (e.g. glass substrate or silicon substrate) or a flexible substrate (e.g. film substrate). The interconnect substrate 40 includes an electrical connection section 42. The electrical connection section 42 may be part of an interconnect pattern of the interconnect substrate 40. The semiconductor device 1 may be mounted so that the active surface of the semiconductor chip 10 faces the interconnect substrate 40. The electrical connection section 42 of the interconnect substrate 40 and the electrical connection section 30 may be in contact and be electrically connected. In more detail, the electrical connection section 30 of the semiconductor device 1 may be in contact and be electrically connected with the electrical connection section 42 of the interconnect substrate 40. This allows the electrical connection section 30 to be pressed against the electrical connection section 42 due to the elasticity of the resin protrusion 20. Therefore, a semiconductor device with excellent electrical connection reliability can be provided. The semiconductor device 1 may be bonded to the interconnect substrate 40 using an adhesive 50. The semiconductor device 1 may adhere to the interconnect substrate 40 through the adhesive 50. The resin protrusion 20 may be maintained in an elastically deformed state by maintaining the semiconductor device 1 and the interconnect substrate 40 at a specific interval using the adhesive 50. The semiconductor device 1 may be directly mounted on a glass substrate of an electronic module 1000 (not shown). In this case, an interconnect pattern of the electronic module 1000 may be formed on glass. When the interconnect pattern of the electronic module 1000 is formed on glass, the semiconductor device 1 is mounted using a chip on glass (COG) mounting method. The connection mechanism may be similar to that described above.

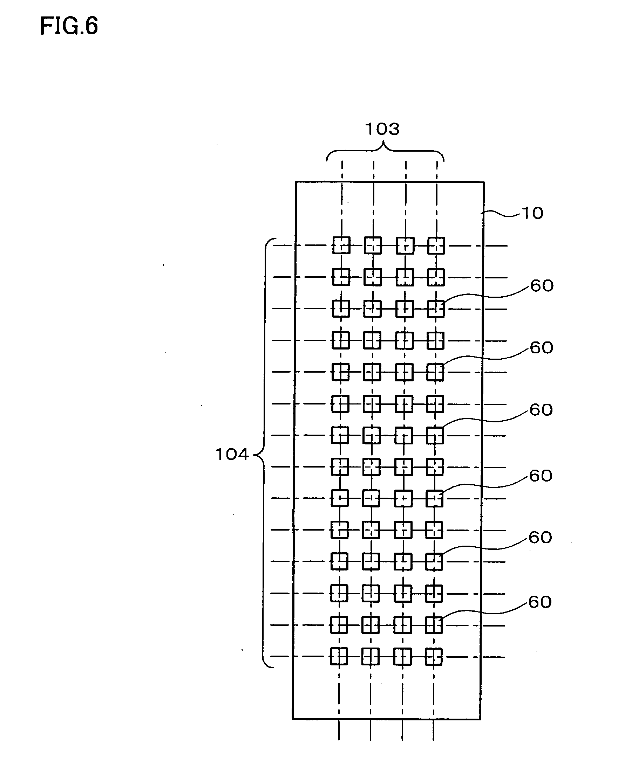

FIG. 5 illustrates the electronic module 1000 on which the semiconductor device 1 is mounted. The electronic module 1000 may be a display device. The display device may be a liquid crystal display device, an electroluminescent (EL) display device, or the like. The semiconductor device 1 may be a driver IC which controls the display device.

According to this embodiment, a semiconductor device can be provided which can be reduced in size and exhibits high reliability. The effects of this embodiment are described below.

According to related-art technology, the electrodes of the semiconductor chip are generally formed in a peripheral region of the active surface to avoid a center region (region overlapping an integrated circuit). This aims at preventing the characteristics of the integrated circuit from being changed due to the pressure applied during mounting, for example. In more detail, a force may be applied to the electrodes when mounting the semiconductor device or packaging the semiconductor chip. In this case, when the integrated circuit is disposed directly under the electrode, a force may be applied the integrated circuit during mounting, whereby the characteristics of the integrated circuit may change. In order to prevent such a problem, it may be necessary to dispose the electrode so that the electrode does not overlap the integrated circuit. This may pose limitations to the arrangement of the electrodes, whereby the design of the integrated circuit may be limited.

In the semiconductor device 1, the electrical connection section 30 is utilized as the external terminal, as described above. The electrical connection section 30 is formed on the resin protrusion 20. Therefore, the semiconductor device 1 can be mounted without applying a force to the electrode 14. As a result, this embodiment allows provision of a semiconductor device in which the characteristics of the integrated circuit 12 do not change during mounting even if the electrode 14 is formed on the integrated circuit 12. Specifically, this embodiment ensures the reliability of the integrated circuit 12 even if the electrodes 14 are arbitrarily disposed, whereby the electrodes 14 can be arranged at a high density.

Accordingly, this embodiment can increase the degrees of freedom of the design of the integrated circuit 12 of the semiconductor chip 10. In related-art technology, internal interconnects have been provided in the semiconductor chip in order to dispose the electrodes so that the electrodes do not overlap the integrated circuit 12. However, it becomes difficult to provide the internal interconnects as the semiconductor device is scaled down and the degree of integration of the integrated circuit is increased. It is expected that the design of the integrated circuit 12 is limited due to the limitations to the internal interconnects. According to the semiconductor device 1, since limitations to the arrangement of the electrodes 14 are reduced, limitations to the design of the integrated circuit 12 can be reduced. Therefore, the degrees of freedom of the design of the integrated circuit 12 can be increased. Specifically, the semiconductor device 1 allows provision of a semiconductor device which allows utilization of the semiconductor chip 10 with high degrees of freedom of the design of the integrated circuit 12. Since the degrees of freedom of the design of the integrated circuit 12 are increased, the formation region of the integrated circuit 12 can be reduced while ensuring the reliability of the integrated circuit 12. According to this embodiment, the formation region of the electrodes 14 can be reduced by arranging the electrodes 14 in rows and columns. Therefore, the semiconductor device 1 allows provision of a highly reliable semiconductor device with a small external shape.

The size of the semiconductor chip 10 can be further reduced by arranging the I/O cells in rows and columns. Specifically, the area occupied by the I/O cells can be reduced and the integrated circuit 12 of the semiconductor chip 10 can be designed with a reduced area by arranging the I/O cells in rows and columns. As a result, the size of the semiconductor chip 10 can be reduced. A space for forming the electrodes need not be provided outside the formation region of the I/O cells by forming the electrodes 14 (electrodes 18) on the I/O cells (to overlap at least part of the I/O cells), whereby the size of the semiconductor chip 10 can be further reduced. As described above, the semiconductor device 1 can be mounted without applying a force to the electrode 14. Therefore, the reliability of the semiconductor device can be ensured even if the electrodes 14 are formed on the I/O cells.

According to the semiconductor device 1, a highly versatile semiconductor device can be provided. In more detail, the semiconductor device 1 allows the electrical connection sections 30 to be formed at the same positions even if the semiconductor chip differs in the arrangement of the electrodes 14 (design of the integrated circuit 12). Therefore, semiconductor chips which differ in the design of the integrated circuit 12 can be mounted on a single interconnect substrate. Or, the arrangement of the electrical connection sections 30 can be changed even if the semiconductor chip 10 has an integrated circuit 12 of the same design. Therefore, semiconductor chips in which the same type of integrated circuit is formed can be mounted on interconnect substrates of different designs.

FIG. 6 is a view illustrative of a semiconductor device according to a modification of an embodiment to which the invention is applied. In FIG. 6, the resin protrusion 20 and the interconnect 32 (electrical connection section 30) are omitted for convenience of illustration. In the semiconductor device according to this embodiment, all electrodes 60 of the semiconductor chip 10 may be disposed at the intersection points of first imaginary straight lines 103 extending in parallel and second imaginary straight lines 104 extending in parallel. As shown in FIG. 6, the first and second imaginary straight lines 103 and 104 may be straight lines which perpendicularly intersect. The first and second imaginary straight lines may be respectively arranged at equal intervals. In more detail, the first imaginary straight lines 103 may be arranged at equal intervals. The second imaginary straight lines may also be arranged at equal intervals. In this case, the first imaginary straight lines 103 and the second imaginary straight line 104 may be arranged at the same intervals. Note that the first and second imaginary straight lines may be straight lines which diagonally intersect (not shown). This embodiment can also provide a semiconductor device which exhibits high reliability and can be reduced in size.

In another modification of an embodiment to which the invention is applied, the semiconductor device may include a semiconductor substrate in the shape of a wafer (not shown). In this case, the semiconductor substrate in the shape of a wafer includes regions in which the semiconductor chips 10 are respectively formed. The semiconductor substrate in the shape of a wafer has a configuration in which the above structure is formed in units of the regions in which the semiconductor chips 10 are respectively formed. The above semiconductor device including the semiconductor chip 10 can be provided by cutting the semiconductor substrate in the shape of a wafer into individual pieces.

Although only some embodiments of the invention have been described in detail above, those skilled in the art will readily appreciate that many modifications are possible in the embodiments without materially departing from the novel teachings and advantages of this invention. Accordingly, all such modifications are intended to be included within the scope of the invention.

## Claims

1. A semiconductor device comprising:
a semiconductor chip in which an integrated circuit is formed;
a plurality of electrodes formed in a first region of the semiconductor chip and arranged in a plurality of rows and a plurality of columns;
a plurality of resin protrusions formed in a second region of the semiconductor chip, the second region surrounding the first region; and
a plurality of electrical connection sections formed on the resin protrusions and electrically connected to the electrodes.

2. The semiconductor device as defined in claim 1,
wherein the electrodes include a group of electrodes arranged in a plurality of rows and a plurality of columns;
wherein the electrodes of the group are disposed at intersection points of first imaginary straight lines extending in parallel with one another and second imaginary straight lines intersecting the first imaginary straight lines; and
wherein part of the electrical connection sections electrically connected to the electrodes of the group are formed on at least one of the resin protrusions extending parallel to the first imaginary straight lines, the number of the resin protrusions on which the part of the electrical connection sections are formed being less than the number of the first imaginary straight lines.

3. The semiconductor device as defined in claim 2,
wherein the part of the electrical connection sections electrically connected to the electrodes of the group are formed on one of the resin protrusions.

4. The semiconductor device as defined in claim 2 or 3,
wherein the first and second imaginary straight lines perpendicularly intersect.

5. The semiconductor device as defined in claim 2 or 3,
wherein the first and second imaginary straight lines diagonally intersect.

6. The semiconductor device as defined in any one of claims 2 to 5,
wherein the semiconductor chip is rectangular; and
wherein the first imaginary straight lines are parallel to short sides of the semiconductor chip.

7. The semiconductor device as defined in any one of claims 2 to 5,
wherein the semiconductor chip is rectangular; and
wherein the first imaginary straight lines are parallel to long sides of the semiconductor chip.

8. The semiconductor device as defined in any one of claims 1 to 7,
wherein a plurality of I/O cells arranged in a plurality of rows and a plurality of columns are formed on the semiconductor chip; and
wherein each of the electrodes is electrically connected to one of the I/O cells.

9. The semiconductor device as defined in claim 8,
wherein each of the electrodes of the group is formed on corresponding one of the I/O cells.

10. The semiconductor device as defined in any one of claims 1 to 9,
wherein the electrodes are formed to cover at least part of the integrated circuit.
